# EUROPEAN PATENT APPLICATION

(11) **EP 3 046 127 A1**
(43) Date of publication of application: **20.07.2016**
(21) Application number: 14844247.8
(22) Date of filing: 09.09.2014
(51) Int. Cl.: H01H 33/00, G01R 31/327, G01R 31/333, H01H 73/00

(54) **DEVICE FOR TESTING DC CIRCUIT BREAKER AND TESTING METHOD THEREFOR**

(30) Priority: 13.09.2013 JP 2013191144
(71) Applicant: Kabushiki Kaisha Toshiba, Minato-ku Tokyo 105-8001 (JP)
(72) Inventor: KUSUYAMA, Hiroshi, Tokyo 105-8001 (JP); KOSHIZUKA, Tadashi, Tokyo 105-8001 (JP); OHDA, Yoshiaki, Tokyo 105-8001 (JP); SATO, Masayuki, Tokyo 105-8001 (JP); MATSUI, Yuki, Tokyo 105-8001 (JP)
(74) Representative: Awapatent AB
(86) International application number: PCT/JP2014/004622
(87) International publication number: WO 2015/037223

(57) **Abstract**

The test apparatus of a direct current circuit breaker (1) for cutting off a direct current has the following configuration. (a) A steady state electric current providing system that provides a direct current to the direct current circuit breaker (1). (b) A fault electric current providing system that provides an alternate current larger than the direct current provided by the steady state electric current providing system to the direct current circuit breaker (1). (c) The steady state electric current providing system and the fault electric current providing system are different systems with respect to the direct current circuit breaker (1).

## Description

### FIELD

An embodiment of the present invention relates to a test apparatus for inspecting cutoff (interruption) performance of a direct current circuit breaker, and a test method therefor.

### BACKGROUND

A conversion device for converting an alternate current into a direct current uses a conversion device called an externally commutated type using a thyristor and the like, and is used to perform direct current electric power transmission. In recent years, researches have been conducted on self-commutated conversion devices using a PWM (Pulse Width Modulation) inverter, converter, and the like.

A self-commutated conversion device is constant voltage controlled, and therefore, when a failure occurs in a direct current system, a fault electric current increases just like a failure in an alternate current system. When the direct current system is multi terminal configuration, a circuit breaker for cutting off (interrupting)a direct current like a circuit breaker used an alternate current system is required. This direct current circuit breaker is also currently under development. In order to inspect the cutoff performance in the development of the direct current circuit breaker, a cutoff test is to be carried out under a condition simulating a failure condition expected to occur in an actual direct current system. In order to do this, it is necessary to have a test apparatus capable of providing an electric current corresponding to a fault electric current in the direct current system. An example of such test apparatus is shown in English document, JURGEN HAFNER, BJORN JACOBSON "Proactive Hybrid HVDC Breaker - A key innovation for reliable HVDC grids" CIGRE International Symposium in Bologna, 2011" (hereinafter referred to as Non Patent Literature 1).

### [Citation List]

### [Non Patent Literature]

Non Patent Literature 1: JURGEN HAFNER, BJORN JACOBSON "Proactive Hybrid HVDC Breaker - A key innovation for reliable HVDC grids" CIGRE International Symposium in Bologna, 2011

In the fault electric current in a direct current electric power transmission using the self-commutated conversion device as described above, the time constant of increment is determined by an inductance and a resistance of a system from the electric power supply to the failure point. In Non Patent Literature 1, in order to provide a fault electric current, a capacitor C is inserted into an electric power supply circuit and a reactor L is disposed in series to the circuit breaker, and the same electric power supply circuit provides the direct current and the fault electric current. After the fault electric current is cut off, a predetermined recovery voltage is required to be applied to the cutoff unit of the direct current circuit breaker. In Non Patent Literature 1, the electric power supply circuit is commonly used, and therefore, a rectifying device (rectifier) needed for providing the direct current is required to be a high-voltage rectifying device that can be used with a voltage equivalent to the recovery voltage. However, when a high-voltage rectifying device is used, there is a problem in that the size of the test apparatus increases, and a very high cost is required to introduce equipment.

A test apparatus of a direct current circuit breaker according to the present embodiment is made to solve the above problems, and a test apparatus and a test method therefor are provided to be able to perform a test of a direct current circuit breaker without introducing an expensive and large-sized high-voltage rectifying device as long as high electric power test equipment of a generally-available alternate current circuit breaker such as a short-circuit electric generator is provided.

In order to achieve the above object, a test apparatus of a direct current circuit breaker for cutting off a direct current according to the present embodiment includes the following configuration.
(1) A steady state electric current providing unit that provides a direct current to the direct current circuit breaker.
(2) A fault electric current providing unit that provides an alternate current larger than the direct current provided by the steady state electric current providing unit to the direct current circuit breaker.
(3) The steady state electric current providing unit and the fault electric current providing unit are different systems with respect to the direct current circuit breaker.

A test method of the direct current circuit breaker is also an aspect of the present invention.

### BRIEF DESCRIPTION OF THE DRAWINGS

Fig. 1 is a circuit diagram illustrating a configuration of a test apparatus of a direct current circuit breaker according to a first embodiment.
Fig. 2 is an electric current waveform diagram of the test apparatus according to the first embodiment, and more specifically, a waveform diagram illustrating a direct current, a fault electric current, and a surge absorber electric current.
Fig. 3 is a circuit diagram illustrating a direct current flowing during a test according to the first embodiment.
Fig. 4 is a circuit diagram illustrating a direct current and a fault electric current flowing during a test according to the first embodiment.
Fig. 5 is a circuit diagram illustrating a direct current, a fault electric current, and a surge absorber electric current flowing during a test according to the first embodiment.
Fig. 6 is a circuit diagram illustrating a direct current and a surge absorber electric current flowing during a test according to the first embodiment.
Fig. 7 is a circuit diagram illustrating an electric current flowing during a test according to the first embodiment.

### DETAILED DESCRIPTION OF THE PREFERRED EMBODIMENTS

### [First embodiment]

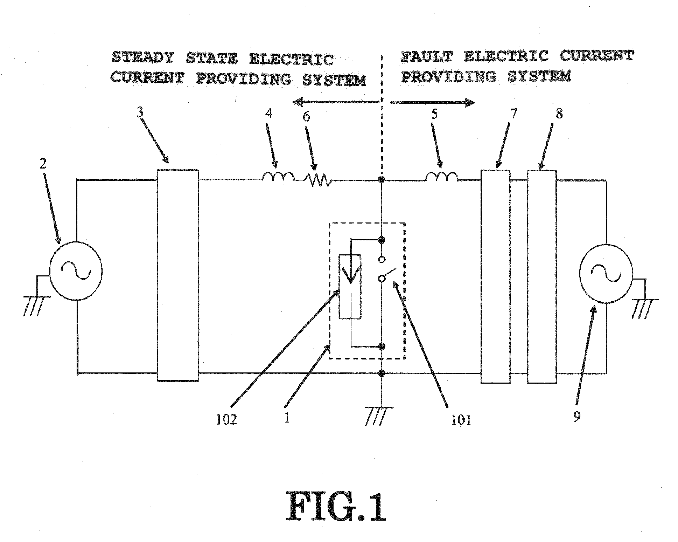

A test apparatus of a direct current circuit breaker and a test method according to the present embodiment will be explained hereinafter with reference to FIGS. 1 to 3. Throughout the drawings, the same portions are denoted with the same reference numerals, and repeated explanation thereabout is omitted as necessary.

The test apparatus of the direct current circuit breaker according to the present embodiment includes a steady state electric current providing unit that provides a direct current to a direct current circuit breaker of a test target, and a fault electric current providing unit that provides an alternate current larger than the direct current provided by the steady state electric current providing unit. In the test of the direct current circuit breaker, the test is conducted according to the following procedure.
(1) When the test starts, a steady state electric current is provided to the direct current circuit breaker from the steady state electric current providing unit.
(2) The turn-on switch unit of the fault electric current providing unit is turned on, so that the fault electric current is provided to the direct current circuit breaker.
(3) The electric current is cut off by the cutoff unit of the direct current circuit breaker, and the surge absorber limits the magnitude of the fault electric current.
(4) The fault electric current of which the magnitude is limited is cut off by the protection circuit breaker of the fault electric current providing unit.
(5) The steady state electric current is attenuated by the surge absorber.

### (Overall configuration)

Fig. 1 is a circuit diagram of a test apparatus of the direct current circuit breaker according to an embodiment of the present invention. The test apparatus according to the present embodiment includes a direct current circuit breaker 1, a short-circuit electric generator 2, a rectifying device (rectifier) 3, reactors 4, 5, a resistance 6, a turn-on switch unit 7, a protection circuit breaker 8, and a short-circuit electric generator 9. In addition, the test apparatus according to the present embodiment includes a control unit for checking the states of the direct current circuit breaker 1, the short-circuit electric generator 2, the turn-on switch unit 7, the protection circuit breaker 8, and the short-circuit electric generator 9 constituting the test apparatus, and for controlling the direct current circuit breaker 1, the short-circuit electric generator 2, the turn-on switch unit 7, the protection circuit breaker 8, and the short-circuit electric generator 9.

The direct current circuit breaker 1 is a circuit breaker for cutting off the direct current flowing in the direct current circuit breaker 1 in accordance with two different methods. The direct current circuit breaker 1 includes a cutoff unit 101 and an energy absorbing unit 102. The cutoff unit 101 and the energy absorbing unit 102 are disposed in parallel.

The cutoff unit 101 is a switch for performing cutoff/turn-on operation of an electric current passing through the circuit. The cutoff unit 101 can be made of, for example, a semiconductor and a mechanical switch for mechanically performing cut-off/turn-on operation.

The energy absorbing unit 102 is a so-called surge absorber (hereinafter referred to as a surge absorber 102). The surge absorber 102 absorbs energy of a transient high voltage applied to the surge absorber 102. With the surge absorber 102, the cutoff unit 101 can limit the magnitude of the voltage after the cutoff.

The direct current circuit breaker 1 is connected to two different systems including a steady state electric current providing system that provides a steady state electric current to the direct current circuit breaker 1 and a fault electric current providing system that provides a fault electric current. The steady state electric current providing system includes an electric power supply for providing a direct current to the direct current circuit breaker 1, and the fault electric current providing system includes a fault electric current providing electric power supply. Hereinafter, the detailed configuration of the test apparatus of the direct current circuit breaker according to the present embodiment will be explained.

### (Steady state electric current providing system)

The steady state electric current providing system provides a direct current to the direct current circuit breaker. The steady state electric current providing system includes a short-circuit electric generator 2, a rectifying device 3, a reactor 4, and a resistance 6. The turn-on switch unit for connecting the short-circuit electric generator 2 with the test circuit and the protection circuit breaker for disconnecting it are not shown.

The short-circuit electric generator 2 is an electric generator generating a short-circuit electric current. The short-circuit electric current generated by the short-circuit electric generator 2 is an alternate electric current. The short-circuit electric current generated by the short-circuit electric generator 2 is output to the rectifying device 3.

The rectifying device 3 is a rectifying device rectifying the alternate current generated by the short-circuit electric generator 2 into a direct current. In the test apparatus, the rectifying device 3 is configured to function as an alternate current-to-direct current conversion unit. The direct current converted (inverted) by the rectifying device 3 is provided via the reactor 4 and the resistance 6 to the direct current circuit breaker 1.

### (Fault electric current providing system)

The fault electric current providing system provides the fault electric current to the direct current circuit breaker 1. This fault electric current is an alternate current larger than the direct current provided to the direct current circuit breaker 1 by the steady state electric current providing system. The fault electric current providing system includes the reactor 5, the turn-on switch unit 7, the protection circuit breaker 8, and the short-circuit electric generator 9.

The short-circuit electric generator 9 is an electric generator generating a short-circuit electric current. The short-circuit electric generator 9 includes an electric power supply circuit of a voltage higher than the short-circuit electric generator 2, and generates a fault electric current larger than the short-circuit electric current generated by the short-circuit electric generator 2. The short-circuit electric current generated by the short-circuit electric generator 9 is provided to the direct current circuit breaker 1 via the protection circuit breaker 8, the turn-on switch unit 7, and the reactor 5.

The protection circuit breaker 8 is a cutoff unit for cutting off the fault electric current flowing through the fault electric current providing system in response to cut-off/turn-on operation. The protection circuit breaker 8 cuts off the fault electric current at an electric current zero point of the fault electric current flowing through the fault electric current providing system.

The turn-on switch unit 7 is a switch unit for connecting or disconnecting the fault electric current providing system to/from the direct current circuit breaker in accordance with cut-off/turn-on operation.

### (Operations)

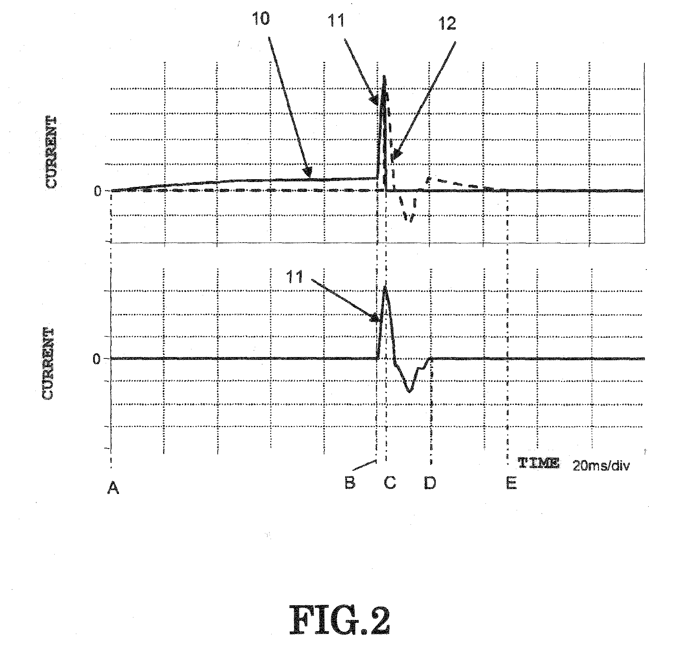

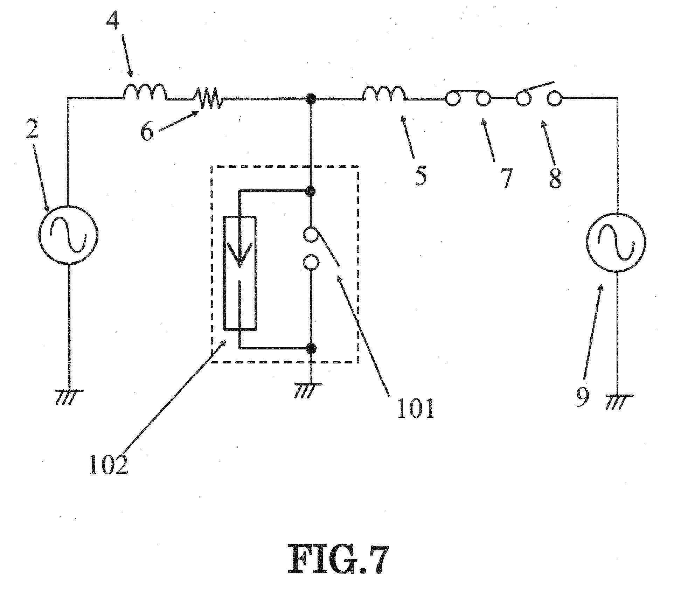

Operation performed by the test apparatus of the direct current circuit breaker according to the present embodiment configured as described above will be explained in details with reference to FIGS. 2 to 7. In the test of the direct current circuit breaker 1, while the direct current is provided to the direct current circuit breaker 1 from the steady state electric current system, the test is carried out by further providing the fault electric current to the direct current circuit breaker 1 from the fault electric current providing system. Hereinafter, the detailed configuration of the test of the direct current circuit breaker according to the present embodiment will be explained.

Fig. 2 illustrates an electric current waveform in the process since the start of the test to when the direct current and the fault electric current are provided to the direct current circuit breaker 1, and the fault electric current is cut off. The direct current 10 is provided from the electric power supply circuit for providing a low voltage direct current, and flows through the cutoff unit 101 of the direct current circuit breaker 1. The fault electric current 11 is provided from the electric power supply circuit for providing a high voltage fault electric current, and flows through the cutoff unit 101 of the direct current circuit breaker 1. The surge absorber electric current 12 is an electric current flowing to the surge absorber 102 after the cutoff unit 101 of the direct current circuit breaker 1 cuts off the current.

### (1) At the start of the test

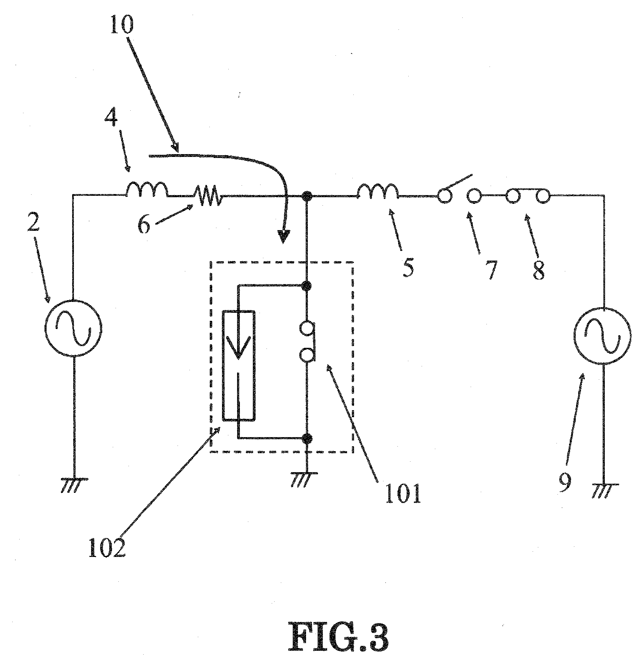

When the test starts, as shown in Fig. 3, the direct current circuit breaker 1 (the cutoff unit 101) and the protection circuit breaker 8 are in the closed state, and the turn-on switch unit 7 is in the open state, and the steady state electric current is provided to the direct current circuit breaker from the steady state electric current providing unit. At the point in time A of the temporal axis of Fig. 2, the short-circuit electric generator 2 is excited, and the alternate current provided from the short-circuit electric generator 2 is inverted by the rectifying device 3 into the direct current. The direct current 10 increasing with a time constant determined by the inductance of the reactor 4, the resistance 6, and the connecting bus-bar provided from the rectifying device 3 to the direct current circuit breaker is provided to the direct current circuit breaker 1.

On the other hand, the short-circuit electric generator 9 is excited with a predetermined voltage in advance, and is disconnected from the direct current circuit breaker 1 by the turn-on switch unit 7. As shown in Fig. 2 the direct current 10 is substantially in the steady state at the point in time B of the temporal axis.

### (2) Providing of the fault electric current

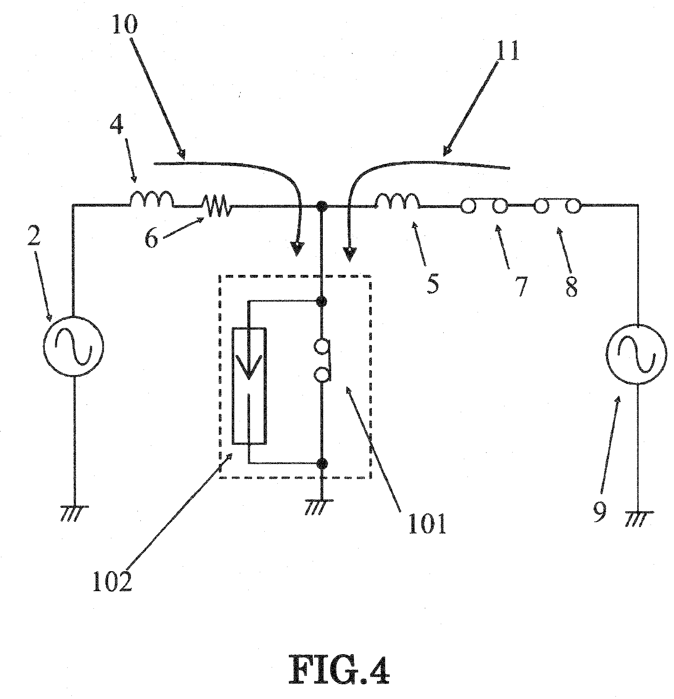

Subsequently, the fault electric current 11 is provided to the direct current circuit breaker 1. To provide the fault electric current 11, as shown in Fig. 4, the turn-on switch unit 7 in the cutoff state is turned on, and the fault electric current providing system is connected to the direct current circuit breaker 1. When the turn-on switch unit 7 is turned on at the point in time B of the temporal axis of Fig. 2, the fault electric current 11 of which the magnitude is determined by the reactor 5 and the output voltage of the short-circuit electric generator 9 is provided to the direct current circuit breaker 1, and an electric current having the fault electric current 11 overlaid (superimposed) on the direct current 10 flows to the direct current circuit breaker 1.

### (3) Cutoff of the cutoff unit 101

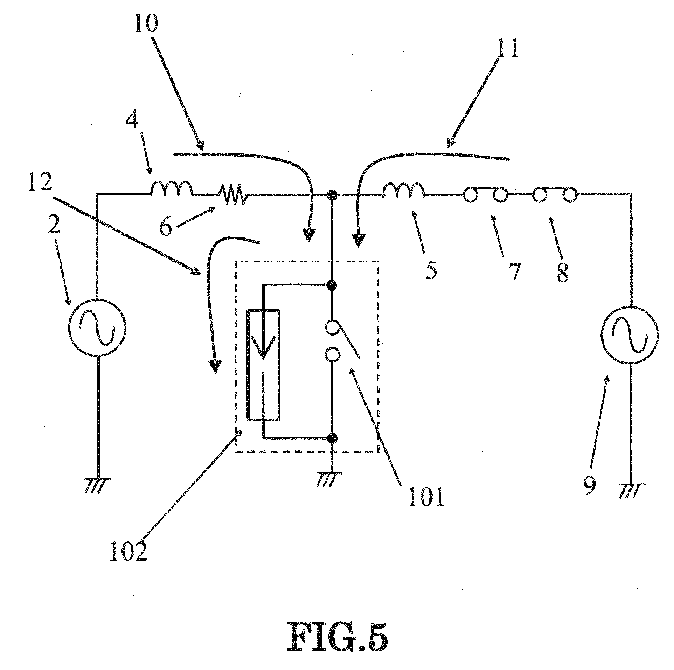

Thereafter, the electric current is cut off by opening the cutoff unit 101 as shown in Fig. 5. When the direct current 10 and the fault electric current 11 are cut off by opening the cutoff unit 101 at the point in time C of the temporal axis as shown in Fig. 2, the surge absorber 102 operates with the voltage generated in the reactors 4 and 5. Therefore, the fault electric current 11 provided from the short-circuit electric generator 9 flows to the surge absorber 102. At the same time, the steady state electric current 10 also flows from the steady state electric current providing unit to the surge absorber 102. More specifically, the surge absorber electric current 12 flowing through the surge absorber 102 is an electric current having the steady state electric current 10 and the fault electric current 11 overlaid (superimposed).

### (4) Cutoff of fault electric current

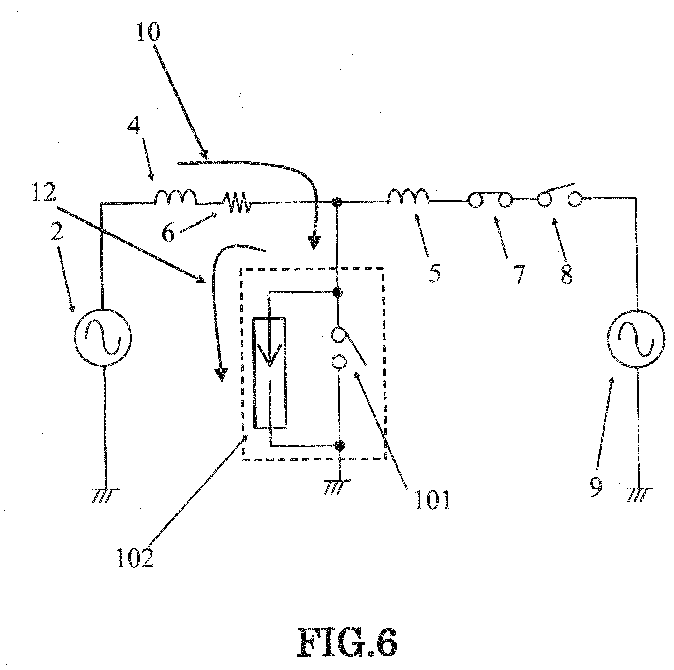

When the fault electric current 11 provided to the surge absorber 102 from the short-circuit electric generator 9 is provided after the cutoff of the cutoff unit 101, the protection circuit breaker 8 is changed to the cutoff state to cut off the fault electric current 11 as shown in Fig. 6.

The fault electric current 11 flowing through the surge absorber 102 is an alternate current of which the magnitude is limited by the surge absorber 102. As a result, the cutoff operation can be done with the protection circuit breaker 8 at the electric current zero point. One of the electric current zero points of the fault electric current 11 is the point in time D in Fig. 2. At the electric current zero point immediately after C, the protection circuit breaker 8 may perform cutoff operation.

When the fault electric current is provided, the fault electric current 11 flows to the direct current circuit breaker 1, and therefore, it never flows to the steady state electric current providing system. Further, even when the cutoff unit 101 is in the cutoff state, the fault electric current 11 flows to the surge absorber 102, and it is cut off by the protection circuit breaker 8 at the electric current zero point. Therefore, a high voltage of the short-circuit electric generator 9 is not applied to the low voltage electric power supply circuit.

### (5) Attenuation of steady state electric current

As shown in Fig. 6, after the fault electric current 11 is cut off, the direct current electric power is provided to the direct current circuit breaker 1 from the steady state electric current providing system. The provided direct current 10 is attenuated by the surge absorber 102, and becomes zero at the point in time E of Fig. 2.

As described above, the electric current at the occurrence of the failure of the direct current system is provided by two systems, i.e., the electric power supply circuit providing the steady state direct current at the low voltage and the electric power supply circuit providing only the fault electric current 11 at the high voltage, and therefore, the cutoff performance of the direct current circuit breaker at the occurrence of the direct current system can be inspected.

### (Advantages)

(1) According to the present embodiment, the electric power supply circuit providing the steady state electric current of the direct current system does not need to apply a high voltage, and the circuit can be configured by a rectifying device of a much lower rate voltage than the recovery voltage applied to the direct current circuit breaker.
(2) Since the circuit providing the fault electric current 11 may provide only the fault electric current 11, without a need for providing the direct current, the fault electric current 11 can be provided with the short-circuit test equipment constituted by the short-circuit electric generator, the turn-on switch unit, and the protection circuit breaker. Therefore, as long as high electric power test equipment of a generally-available alternate current circuit breaker such as a short-circuit electric generator is provided, it is possible to provide a test apparatus of a direct current circuit breaker without introducing an expensive and large-sized high-voltage rectifying device.

### [Other embodiments]

In this specification, multiple embodiments according to the present invention have been explained, but these embodiments are shown as examples, and it is to be understood that the scope of the invention is not limited. More specifically, the first embodiment can be carried out in various other forms, and various kinds of omissions, replacements, and changes can be applied without deviating from the gist of the invention. The embodiment of the modifications thereof are included in the scope and the gist of the invention, and likewise, included in the invention described in claims and the equivalent range thereof.

More specifically, in the first embodiment, the direct current circuit breaker 1, the short-circuit electric generator 2, the rectifying device 3, the turn-on switch unit 7, the protection circuit breaker 8, and the short-circuit electric generator 9 are shown, but it is to be understood that the scope of the invention is not limited. For example, the rectifying device 3 may be an alternate current-to-direct current conversion unit capable of converting the alternate current into the direct current.

## Claims

1. A test apparatus of a direct current circuit breaker for cutting off a direct current, comprising:
a steady state electric current providing unit configured to provide a direct current to said direct current circuit breaker; and
a fault electric current providing unit configured to provide an alternate current larger than a direct current provided from said steady state electric current providing unit to said direct current circuit breaker,
wherein said steady state electric current providing unit and said fault electric current providing unit are provided in different systems with respect to said direct current circuit breaker.

2. The test apparatus of said direct current circuit breaker according to claim 1,
wherein said steady state electric current providing unit includes:
a first short-circuit electric generator unit configured to generate an alternate current; and
an alternate current-to-direct current conversion unit configured to convert said alternate current generated by said first short-circuit electric generator unit into a direct current.

3. The test apparatus of the direct current circuit breaker according to claim 1 or claim 2,
wherein said fault electric current providing unit includes:
a second short-circuit electric generator unit configured to generate an alternate current; and
a turn-on switch unit configured to perform cutoff and turn-on of an electric current.

4. The test apparatus of said direct current circuit breaker according to claim 3,
wherein said fault electric current providing unit further includes a protection circuit breaker.

5. A test method of a direct current circuit breaker for cutting off a direct current, comprising:
steady state electric current providing unit processing in which an electric power system provides a direct current having a magnitude flowing in a steady state to said direct current circuit breaker; and
fault electric current providing processing in which a fault electric current flowing when abnormality occurs in said electric power system is provided to said direct current circuit breaker,
wherein said steady state electric current and said fault electric current are provided in different systems with respect to said direct current circuit breaker.

6. The test method of said direct current circuit breaker according to claim 5,
wherein said fault electric current providing processing is performed in parallel with said steady state electric current providing unit processing, and
an electric current having said steady state electric current and said fault electric current overlaid flows to the direct current circuit breaker.

## Amended claims

### Amended claims under Art. 19.1 PCT

**1.** A test apparatus of a direct current circuit breaker for cutting off a direct current, comprising:
a steady state electric current providing unit configured to provide a direct current to said direct current circuit breaker; and
a fault electric current providing unit configured to provide an alternate current larger than a direct current provided from said steady state electric current providing unit to said direct current circuit breaker,
wherein said steady state electric current providing unit and said fault electric current providing unit are provided in different systems with respect to said direct current circuit breaker.

**2.** The test apparatus of said direct current circuit breaker according to claim 1,
wherein said steady state electric current providing unit includes:
a first short-circuit electric generator unit configured to generate an alternate current; and
an alternate current-to-direct current conversion unit configured to convert said alternate current generated by said first short-circuit electric generator unit into a direct current.

**3.** The test apparatus of the direct current circuit breaker according to claim 1 or claim 2,
wherein said fault electric current providing unit includes:
a second short-circuit electric generator unit configured to generate an alternate current; and
a turn-on switch unit configured to perform cutoff and turn-on of an electric current.

**4.** The test apparatus of said direct current circuit breaker according to claim 3,
wherein said fault electric current providing unit further includes a protection circuit breaker.

**6.** The test method of said direct current circuit breaker according to claim 5,
wherein said fault electric current providing processing is performed in parallel with said steady state electric current providing unit processing, and
an electric current having said steady state electric current and said fault electric current overlaid flows to the direct current circuit breaker.
